(19) Europäisches Patentamt

European Patent Office

Office européen des brevets

(11) EP 0 964 317 A1

(12) EUROPEAN PATENT APPLICATION

(43) Date of publication:
15.12.1999 Bulletin 1999/50

(51) Int. Cl.⁶: G03H 1/00, H01L 21/027, G03F 7/20

(21) Application number: 98303677.3

(22) Date of filing: 11.05.1998

(84) Designated Contracting States:
AT BE CH CY DE DK ES FI FR GB GR IE IT LI LU MC NL PT SE
Designated Extension States:
AL LT LV MK RO SI

(71) Applicant:
Holtronic Technologies
London EC4A 1NH (GB)

(72) Inventor: Clube, Francis
2000 Neuchâtel (CH)

(74) Representative:
Hasler, Erich, Dr. et al
Patentanwaltsbüro
Dr. Conrad A. Riederer
Bahnhofstrasse 10
7310 Bad Ragaz (CH)

(54) **Total internal reflection holographic recording and imaging apparatus and a method of forming a hologram and reconstructing an image therefrom**

(57) The present invention relates to a method and an apparatus for forming a hologram from a mask and to a method and an apparatus for reconstructing an image from a hologram in the field of total internal reflection (TIR) holography. A TIR holographic system comprises a prism (11), a substrate (13) bearing a hologram (19) arranged on a first prism face, a wafer (37) bearing a recording medium (39) arranged in a spaced relationship to the hologram (19), a laser light source (25), a beam expansion optics (27), a scanning stage (29) and one or more mirrors (34) for directing the illumination to a second face (35) of the prism (11). In order to compensate more accurately for any unevenness of the wafer and/or hologram surface, the apparatus comprises a beam expansion optics including first one-dimensional compression (45,47) and/or one-dimensional expansion means which are arranged in the light path such that the output of the beam expansion optics is compressed in the first direction relative to the second direction, where the first direction corresponds to the direction of the scan passes in the raster scan pattern of the beam across the first face or hologram and where the second direction corresponds essentially to the stepping direction in the raster scan pattern, to produce a beam whose dimension in the first direction is less than 0.7 times its dimension in the second direction.

Fig. 4

EP 0 964 317 A1

## Description

The present invention relates to a total internal reflection holographic apparatus and a method of forming a hologram and reconstructing an image therefrom.

The principles of total internal reflection (TIR) holography have been described already in US 4,857,425. Since then many efforts have been made to make use of TIR holography in the microelectronics industries. Prior art references are e.g. US 4,917,497, US 4,966,428, 5,187,372, US 5,640,257 and European application no. 98300188 whose contents are herewith incorporated by reference.

US patent 5,640,257 relates to a total internal reflection (TIR) holographic system for recording a hologram wherein an object and a reference beam are scanned across the holographic layer in a raster pattern. As the object beam arrives at the holographic layer at normal incidence and the reference beam at or near 45°, the latter, without any counter measure, would illuminate an area of the recording layer $\sqrt{2}$ times greater than the area occupied by the object beam and furthermore would scan across the layer at a speed $\sqrt{2}$ times faster than the object beam. For this reason US patent 5,640,257 proposes either to employ optical elements in the reference beam path to compress the reference beam in the plane of incidence of the reference beam at the holographic layer or to employ optical elements in the object beam path to expand the object beam. This measure ensures that the superposed beams illuminate the same area and remain perfectly aligned as they scan.

US Ser. No. 08/380148 (cont. of 08/065488 of May 24, 1993) discloses a total internal reflection (TIR) holographic system having a first computer controlled stage for movement of the illumination beam in the x and y directions, especially, in a raster scan, across a hologram which is mounted to a face of a prism. A second computer controlled stage permits translation of a wafer being coated with a photoresist and being arranged parallel to the hologram in the x and y directions. Additional means in the form of piezoelectric transducers allow to adjust dynamically the distance between the hologram and the wafer during the scanning process.

For multi-exposure processes it is important that the features in each layer are accurately registered or aligned with respect to those in other layers. For this purpose reference marks are included in the hologram and on the wafer or substrate and the misalignment between those is measured and then adjusted before each scanning exposure process. As some post-exposure treatments, in particular high-temperature processes, cause irreversible expansion or compaction of the wafer or substrate, they cannot be compensated for by this method alone. For this purpose US Ser. No. 08/380148 proposes to change the scale of a pattern printed from a TIR hologram by adjusting dynamically the relative positions of the hologram and the wafer during the scanning process with respect to two orthogonal axes parallel to the respective planes of the flat substrates. If the change in scale required is a magnification (i.e. an expansion of the printed pattern) the movement of the hologram with respect to the photosensitive layer is in the same direction as that of the scanning beam, whereas if a demagnification, or compression, is required, it is in the opposite direction. As this compensation of the change in scale produces some loss in definition of the printed image US Ser. No. 08/380148 additionally proposes to change the degree of convergence or divergence of the scanning beam so that the image projected from the hologram is itself magnified or demagnified by the appropriate amount. This is achieved by passing the illumination beam through a beam decollimator consisting of two conjugate lenses and adjusting their separation to produce the required amount of decollimation. A prism which is arranged after the beam decollimator compresses the beam in the xz plane (the plane of incidence of the beam at the hologram) by a factor $2^{1/2}$ so that the magnification or demagnification of the image projected from the hologram is the same in both x and y directions.

In order to obtain a uniform exposure of the photosensitive layer in a raster scan as disclosed in US Ser. No. 08/380148 the Gaussian shaped light beam must be scanned beyond the edge of the hologram on each side by at least half of the diameter. Each scan across the width of the hologram corresponds therefore to the width of the hologram (w) plus the beam diameter (d). Since with a raster scan the beam must travel many times across the width of the hologram, the duration of the replay or reconstruction operation can be long.

Although the use of a raster scanning technique combined with a focus system to provide simultaneous measurement and adjustment to a constant value of the gap between the hologram and the wafer during the reproduction operation provide for a significant improvement of the control of the focal plane of the image with respect to the wafer surface (as disclosed in EP-A-0 421 645), the present inventor has found that the unevenness of the wafer surface is often unsatisfactory even over a small area of approx. 2 cm$^2$ which typically corresponds to the diameter of the scanning beam. Accordingly, whereas the image can be accurately focussed onto the wafer surface at the center of the beam (where the gap measurement is normally performed), the limited depth of focus of the image and the non-perfect parallelism of the hologram and wafer surface causes the features imaged at the edge of the beam to be printed away from perfect focus. A possible solution to the aforementioned problem would be to reduce the beam diameter so that the influence of any unevenness of the wafer surface is decreased. This approach, however, would be at the expense of a reasonable scanning time because the stepping distance between successive passes of the scanning beam in the raster scan pattern would also need to be reduced in order to ensure a uniform exposure, and this would increase the number of scan passes resulting in a long printing time. This is not usually tolerated in an industrial production process.

It is therefore an object of the present invention to provide an improved method and an improved total internal reflection (TIR) hologram apparatus for forming a hologram and reconstructing an image therefrom by a scanning technique. In particular, it is an object to provide for a better control of the focus of the image on the wafer surface. A further object is to minimise the scanning time for a raster scan.

According to the invention there is provided an apparatus according to the pre-characterizing part of claim 1 having beam expansion optics including first one-dimensional compression and/or one-dimensional expansion means which are arranged in the light path such that the output of the beam expansion optics is compressed in the first direction relative to the second direction, where the first direction corresponds to the direction of the scan passes in the raster scan pattern of the beam across the first face or hologram and where the second direction corresponds essentially to the stepping direction in the raster scan pattern, to produce a beam whose dimension in the first direction is less than 0.7 times its dimension in the second direction. The claimed beam shape has the advantage that it allows any unevenness of the wafer surface and/or hologram surface to be more accurately compensated by a focus system while allowing a short printing time. The uneven wafer surface is better compensated because the image instantaneously reconstructed from the hologram is concentrated more towards the beam center thus reducing any deviations of the wafer surface from the focal plane of the image in the area of the beam. Prisms can be employed to compress or expand the beam in one dimension such that the diameter of the illumination beam in the scanning direction is significantly smaller than in the stepping direction. In principle, the laser light beam can be first expanded in two directions and subsequently compressed in one direction or, alternatively, expanded in just one direction in order to produce a beam whose dimension in the one direction is less than its dimension in the other direction.

The coupling element is e.g. a prism or a grating on a transparent plate or glass substrate as described in the co-pending European application no. EP 98300188. The coupling element disclosed in EP 98300188 is a glass substrate having a periodic grating structure on the first surface whose period, in relation to the incident angle and wavelength of the light and the refractive index of the plate material is such that only a zeroth and one first order beams of the light being incident on the first surface at a predetermined incident angle are transmitted into the plate and that the transmitted first diffraction order is essentially totally reflected at the second surface/air interface. Thus, the grating can behave like a prism in a TIR holographic process.

Advantageously, the compression and/or expansion means are designed such that a beam of an essentially elliptical or rectangular cross-section is produced and the dimension of the elliptical or rectangular cross-section of the beam in the first direction is about a half or less of its dimension in the second direction and preferably one third or less of its dimension in the second direction. The bigger the compression ratio the smaller the influence of any unevenness of the wafer surface on the quality of the printed pattern. The compression or expansion means can be, for example, prisms, diffraction gratings or cylindrical lenses.

According to a preferred embodiment of the invention the TIR holographic system further comprises means, e.g. mirrors or a right-angle prism with aluminised orthogonal faces, for generating two parallel illumination beams from two light sources.

Advantageously the apparatus comprises means for measuring the gap between the hologram and a wafer, preferably at the centre of the scanning illumination beam, and means for adjusting the separation between the hologram and the wafer.

According to the present invention there is provided also a method of reconstructing an image from a hologram in a total internal reflection hologram imaging apparatus which is characterised in that the illumination beam is compressed in the first direction relative the second direction, where the first direction corresponds to the direction of the scan passes in a raster scan pattern of the beam across the hologram and where the second direction essentially corresponds to the stepping direction in the raster scan pattern, to produce a beam such that its dimension in the first direction (a) is less than 0.7 times its dimension in the second direction (b), and so that in the hologram plane the light beam is scanned in the direction of the smaller beam diameter and stepped in the direction of the larger beam diameter. This allows to enhance the performance by increasing the resolution of the system without increasing the overall scanning time. In this manner the magnitude of distortions of the printed features arising from their limited depth of focus and the non-flatness of the wafer can be reduced significantly relative to the conventional technique and can further result in a slight reduction of the scanning time.

The present invention relates also to a method and a TIR holographic recording apparatus for forming a hologram from a information containing mask according to the characterizing parts of claims 14 and 6, respectively. Advantageous embodiments thereof are similar to those described above in connection with the method and apparatus for reconstructing an image from a hologram.

For a more complete understanding of the present invention, reference is now made to Figs. 1 to 9 of the drawings, like numerals being used for like and corresponding parts of the various drawings.

Fig. 1      is a schematic view of a known total internal reflection (TIR) holographic apparatus comprising a scanning stage for scanning an illumination beam in x and y direction (only x dimension shown);

Fig. 2      the laser source, optic and scanning stage of Fig. 1 from below;

Fig. 3      the path of the illumination beam on the hologram;

Fig. 4      is a schematic view of a first embodiment of a TIR holographic apparatus according to the present invention having compression means in the form of two prisms interposed between the laser source and the scanning system for compressing the beam in the x-direction;

Fig. 5      shows the path of the compressed illumination beam on the hologram;

Fig. 6      is a partial schematic top view of a second embodiment of a TIR holographic apparatus according to the invention which uses two laser sources;

Fig. 7      is a schematic side view of the embodiment of Fig. 6;

Fig. 8      the shape of the compressed and/or expanded illumination beams of Fig. 7 in the hologram plane and their intensity distribution in the x direction;

Fig. 9      a schematic view of the compressed elliptical beam in the xy plane; and

Fig. 10      a schematic view of a third embodiment of the invention having additional compression means in the form of a prism for compressing the reference beam in one dimension.

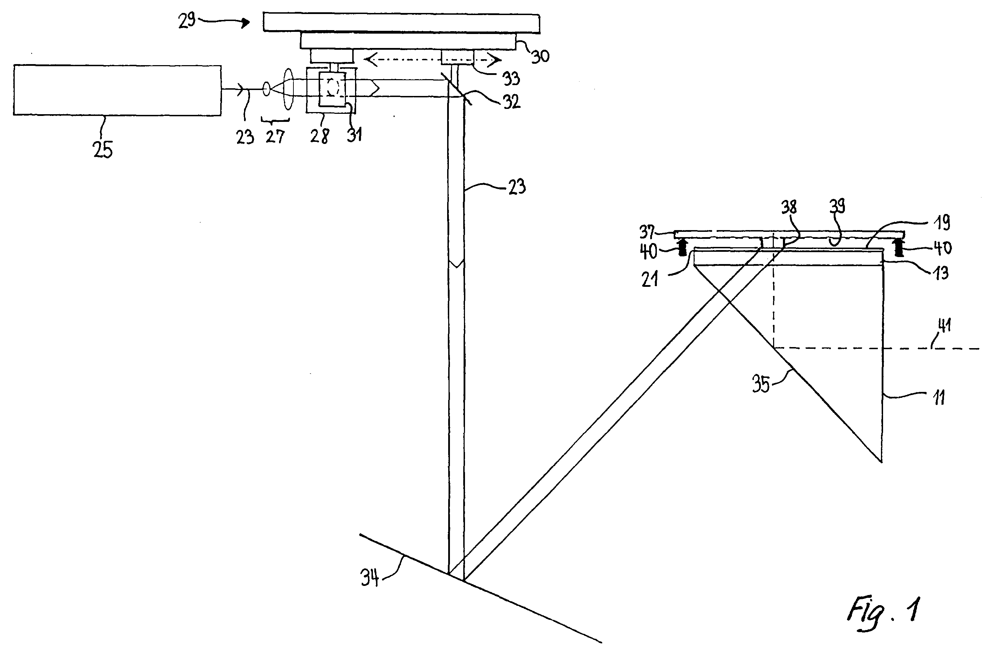

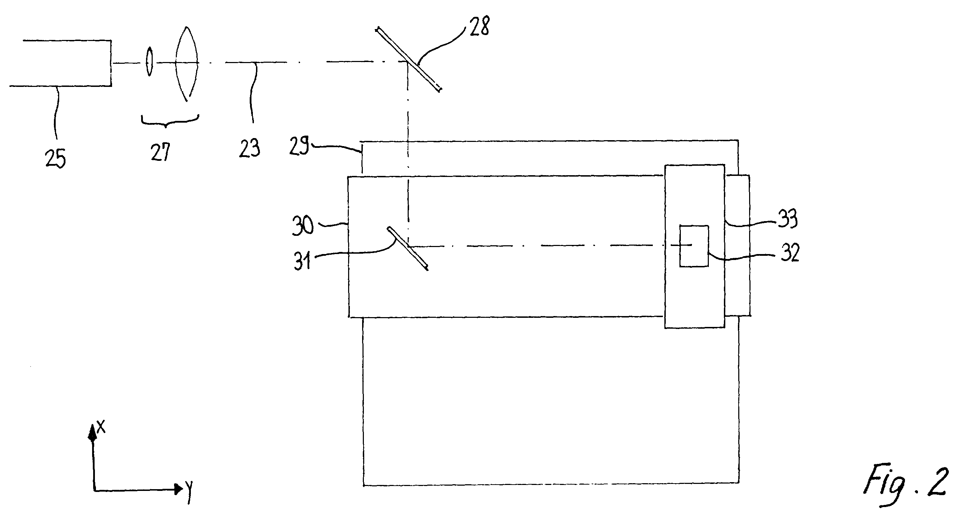

Figures 1 and 2 show a known TIR holographic system for reconstructing an image from a hologram. It usually comprises a prism 11 onto which a substrate 13 having a hologram 19 recorded in a recording layer is index-matched by means of an appropriate matching fluid (indicated by arrow 21 in Fig. 1). The matching fluid 21 is chosen such that it possesses the same refractive index as the prism and substrate material so that a light beam 23 which passes from the prism 11 into the substrate 13 preferably is not reflected at the prism/substrate interface. The incident angle of the light beam 23 is chosen such that total internal reflection occurs at the interface between the recording layer 19 and the ambient air. This condition is met if the angle of the incident light beam 23 is greater than the critical angle.

The light beam 23, which is also named the reconstruction light beam, is usually generated by a laser source 25. The laser light beam 23 is then expanded and collimated to a beam of diameter 15 mm by a known optical expansion means 27. The beam is reflected in the y direction (orthogonal to the plane of the figure) by a mirror 28 towards a two-axes xy scanning stage 29. The two-axes xy scanning stage 29 serves for deflecting the collimated light beam 23 such that the beam can traverse in a raster pattern the entire hologram surface to be reconstructed. For this purpose the scanning stage 29 comprises a first mirror 31 on a first carriage 30 movable in the y direction which deflects the light beam to a second mirror 32 on a second stage 33 moveable in the x direction that is also mounted to the first carriage 30. This second mirror 32 deflects the beam onto a third large mirror 34 such that the light beam 23 enters the prism through the hypotenuse face 35 and arrives at the hologram bearing face at an angle which is greater than the critical angle. For, the orientation of the stage system it is preferable that the beam be scanned in the x direction and stepped in the y direction (it also allows the beam to be scanned in the y direction and stepped in the x direction, though this is not desirable because of mechanical wear to the first stage).

For reconstructing the hologram 19 a second substrate, e.g. a silicon wafer 37 being coated with a photosensitive layer 39, is placed parallel and in proximity to the hologram bearing substrate 13. Thereafter the reconstruction light beam 23 is scanned across the entire hologram in a raster scan-and-step operation. The reconstruction of an image from the hologram 19 requires that the direction of the light beam 23 is in the opposite direction to that of the reference beam in the hologram formation process. The interaction of the light beam 23 with the hologram produces a positive image of the circuit pattern in the photosensitive layer 39 on the silicon wafer 37 (arrow 38 indicates the reconstructed light beam).

In order that the image generated from the hologram is printed in focus in the photosensitive layer, the hologram 19 bearing substrate 13 and the wafer 37 are made parallel and the separation between them is adjusted to the same distance as between the mask and the recording layer during the hologram formation process. For this purpose the wafer 37 is mounted to a vacuum chuck which is positioned on adjustable supports, e.g. piezoelectric transducers 40. The local separation between the hologram 19 and the photosensitive layer 39 is interferometrically measured by a light beam 41 (dashed line in Fig. 1). The light beam 41 is scanned either beforehand or, preferably, simultaneously with the exposure beam 23 scanning across the hologram surface. For each measurement point the interference of the reflections from hologram and the wafer surface is detected from which the local separation between the hologram 19 and the photosensitive layer 39 is determined. As the light beam 41 scans the hologram 19 the distance between the hologram 19 and the wafer 37, where the beam is illuminating the hologram, is continuously measured and then adjusted to the required value (corresponding to the distance between the recording layer and mask during hologram recording).

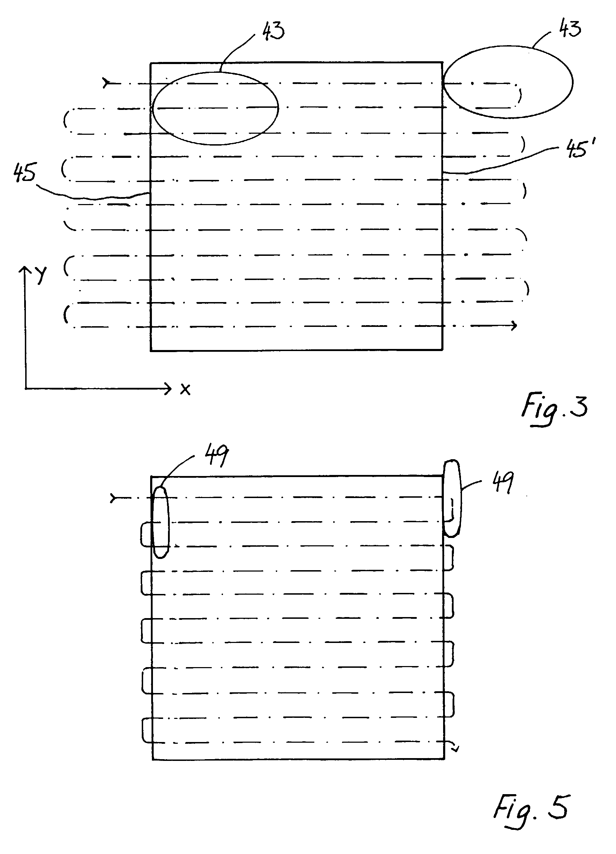

Fig. 3 shows the pattern of the travel of the light beam 23 on the hologram surface. As the light beam 23 which has a circular cross section impinges on the hologram surface at an angle of approx. 45° the light spot on the hologram surface corresponds to an ellipse 43 whose length in the x direction is $\sqrt{2}$ greater than its width in the y direction. The light beam 23 is scanned in the x direction, then stepped in the y direction, then scanned again in x direction and so on.

It will be appreciated that the light beam can alternatively be scanned in the y direction and stepped in the x direction.

As the light beam is usually Gaussian shaped, the stepping distance in the y direction is preferably chosen such that successive scan passes in the x direction overlap by a certain amount in order that the integrated exposure energy over the hologram surface is made very uniform (typically the stepping distance is arranged to be about one third of the beam diameter in the stepping direction). In order to ensure an even illumination near the opposite edges 45,45' of the hologram, the light beam 23 must be scanned beyond said edges so that the stepping of the light beam 23 in the y direction takes place outside the area of the hologram (see dashed ellipse in Fig. 3).

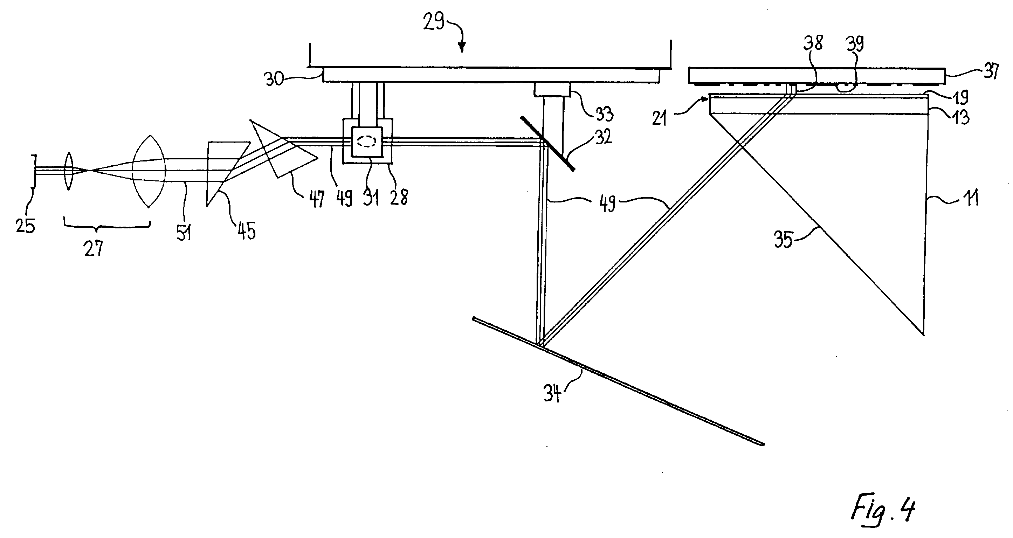

Fig. 4 shows a total internal reflection holographic system according to the invention wherein two right-angle prisms 45,47 are arranged in the light path before the scanning stage 29 such that the beam is compressed in the scanning direction to produce an elliptical or almost rectangular beam in the plane of the hologram. The prisms have anti-reflection coatings on the faces through which the beam passes in order to maximise the power in the beam so as to minimise the time required to print the substrate. The prisms are oriented such that the beam is incident on their first faces at normal incidence. In this case, the magnitude of beam compression factor, c, produced by each prism, is related to the angle $\Theta$ between the two faces of the prism through which the beam passes and to the refractive index, n, of the prism material by

$$c = (1 - n^2 \sin^2 \Theta)^{1/2} / \cos \Theta$$

So, if $\Theta = 36°$ and n = 1.5, then c = 0.58. Hence, for two prisms with $\Theta = 36°$ arranged as shown in the figure, the total beam compression is 0.33 (i.e. the beam has been compressed by a factor of 3).

Clearly, other shapes and orientations of prisms can be employed for achieving the same beam compression. Arranging the prisms 45,47 before the scanning stage 29 has the advantage that the prisms 45,47 configured as shown in the figure can remain stationary. By the use of two identical prisms 45,47 the compressed light beam 49 leaving the second prism 47 can be parallel to the incoming beam 51. It should be noted that for the case where the beam is scanned in the y direction and stepped in the x direction, the two prisms should be oriented such that the beam is compressed in the y direction. For the sake of clarity, in Fig. 4 the adjustment means for adjusting the parallelism and/or separation between the hologram and the wafer are not shown.

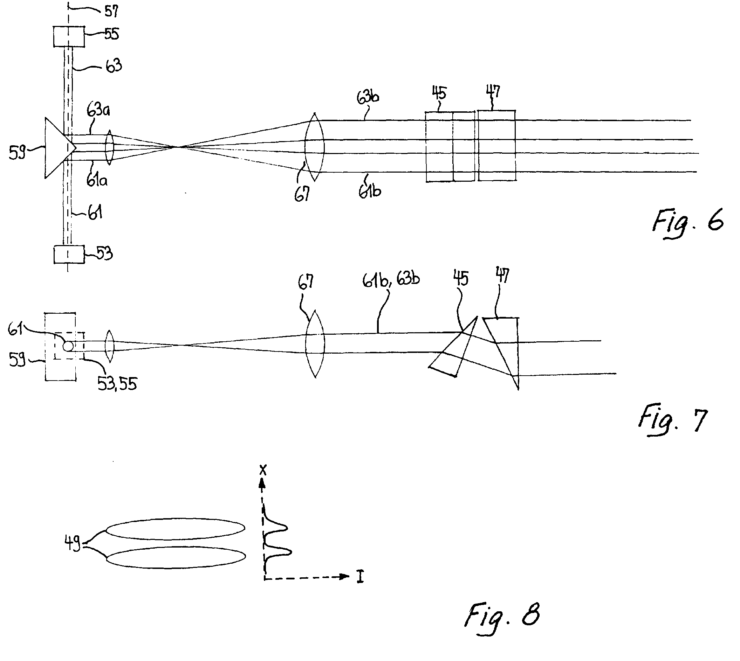

Fig. 5 shows the pattern of the travel of the compressed light beam 49 on the hologram surface. As will be evident from a comparison of Figs. 3 and 5, the compressed light beam 49 must be scanned beyond said edges by a much smaller amount than the elliptical light beam 43. Accordingly, the path length traveled by the compressed scanning beam 49 is smaller than that of the elliptical light beam 43. Thus, the time necessary for scanning the pattern recorded in the hologram will also be shorter than with the conventional scanning technique.

Fig. 6 and 7 show a further embodiment of the invention which uses two laser sources 53,55. The light beams 61,63 emitted from laser sources 53,55 are arranged on an axis 57 which is parallel to the hypotenuse face of a right-angle prism 59.

The two mutually orthogonal faces of the prism have been aluminised so that they act as mirrors. The beams 61,63 are incident on the mirror faces of said right-angle prism 59 at an angle of 45° thereby producing two parallel beams 61a,63a. Preferably, the distance between the two parallel beams 61b,63b is adjusted by the prism 59 to a minimum without scattering occurring from the apex of the prism.

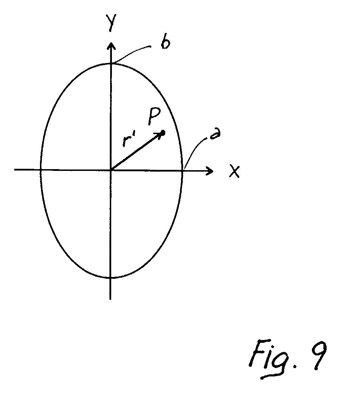

The parallel beams 61a,63a are then expanded and collimated by lenses 65 and 67 into beams 61b,63b. The beams 61b,63b are subsequently expanded by two identical prisms 45,47 in a direction orthogonal to a line through the centers of the beams. Preferably, the prisms 45,47 are arranged such that the beams 61a,63a and 61b,63b before and after the prism 45,47 are parallel. Fig. 8 shows the intensity distribution in the composite beam. For raster scanning the beams, the scan passes are in the direction of the line joining the centres of the two beams and, the scan steps are orthogonal to this with a step size of typically one third of the diameter of the beams in the expanded direction. The use of beams from two laser sources has the advantage that the scanning time can be approximately half of that of an apparatus using just one laser source. The laser sources are typically argon ion lasers which each have a an output power of 2 W at a wavelength of 363.8 nm. As for the single source case, the employment of beam expansion or beam compression optics to compress the beam in the scanning direction relative to the stepping direction reduces degradation of the printed pattern arising from focus errors without compromising the time it takes to print the entire pattern.

This particular embodiment can be extended to three or more parallel beams using additional laser sources and additional beam combining optics.

The method of this invention may also be combined with the method for decollimating the replay beam described in US Ser. No. 08/780148.

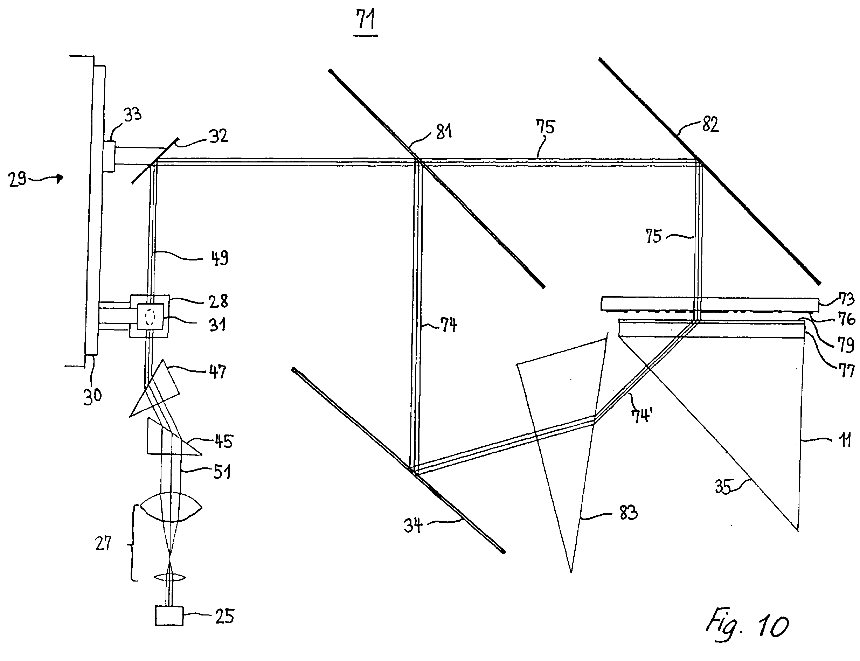

The embodiment of Fig. 10 relates to a TIR holographic apparatus 71 which is used for forming a hologram from a mask 73 containing a pattern 76 to be reproduced. The recording apparatus 71 differs from the apparatus of Fig. 1 in that two collimated and coherent beams, a reference beam 74 and an object beam 75, are provided and that a substrate 77 which is coated with a recording medium 79 is optically coupled to the prism 11. Said object beam 75 is derived from the same light source 25 by means of a beam splitter in the form of a semi-transparent mirror 81. The object beam thus formed is directed by a mirror 82 to the substrate face 73. The incident angle normally is 90° but can be different from that depending on the features to be transferred into the holographic recording medium 79. The European application no. 97103956, for instance, discloses a TIR application where the incident angle of the object beam .... The content of the European application 97103956 is herewith incorporated by reference.

A further prism 83 serves for compressing the reference beam 74 in one direction, namely in the direction of the slanted prism face 85. Otherwise, by the incidence angle of 45° the diameter of the reference beam 74 would be √2 larger in one direction than that of the object beam 75. Instead of or in addition to compressing the reference beam 74 in one direction, the object beam 75 can be expanded in one direction so that both beams match each other in the plane of interference. The compression of the reference beam 74 and/or expansion of the object beam 75 in one direction is described in more detail in the US 5,640,257 whose content is herewith incorporated by reference.

**Claims**

1. Total internal reflection holographic imaging apparatus for reconstructing an image from a hologram (19), comprising

   - a coupling element (11) for receiving a substrate (13) bearing a total internal reflection hologram (19) on a first face;
   - at least one light source (25) for generating a replay or reconstruction light beam (23,51);
   - beam expansion optics (27);
   - means (34) for directing the light beam at a second face of the coupling element (11) such that it illuminates the interface between the first face and the ambient medium or the interface between a substrate (13) in optical contact with said first face and the ambient medium at an angle greater than the critical angle;
   - means (29) for scanning and stepping the replay beam (23,51) in a raster scan across the first face or hologram (19) in a first and in a second direction, respectively;
   **characterized in that**
   - the beam expansion optics (27) includes first one-dimensional compression and/or one-dimensional expansion means (45,47) which are arranged in the light path such that the output of the beam expansion optics (27) is compressed in the first direction relative to the second direction, where the first direction corresponds to the direction of the scan passes in the raster scan pattern of the beam across the first face or hologram (19) and where the second direction corresponds essentially to the stepping direction in the raster scan pattern, to produce a beam (49) whose dimension in the first direction is less than 0.7 times its dimension in the second direction.

2. Apparatus according to claim 1, characterized in that the first compression and/or first expansion means (45,47) are designed such that a beam (49) of an essentially elliptical or rectangular cross-section is produced and that the dimension of the cross-section of the beam (49) in the first direction is about a half or less of its dimension in the second direction and preferably one third or less of its dimension in the second direction.

3. Apparatus according to claim 1 or 2, characterized in that the first compression or expansion means (45,47) include prisms, diffraction gratings or cylindrical lenses.

4. Apparatus according to any of the preceding claims 1 to 3 further comprising means, such as mirrors or a right-angle prism (59) with aluminised orthogonal faces or the like, for generating two or more parallel light beams (61,63) from two or more light sources (53,55) which beams (61,63) are spatially separated at the hologram (19) in the first direction.

5. Apparatus according to any of the preceding claims 1 to 4 further comprising

   - means for measuring the gap between the hologram (19) and a wafer (37) being arranged in a spaced relationship to the hologram (19); and
   - means (40) for adjusting the parallelism and/or separation between the hologram (19) and the wafer (37).

6. Total internal reflection holographic recording apparatus (71) for recording a hologram (19) from a mask (37), comprising

- a coupling element (11) for receiving a substrate (77) bearing a holographic recording medium (79) on a first face;
- one light source (25) for generating a light beam (51);
- beam expansion optics for expanding the light beam into a collimated incident light beam (27);
- means (81), e.g. a beam-splitter, for generating two coherent light beams, a reference light beam (74) and an object light beam (75);
- means (34) for directing the reference light beam (74) at a second face (35) of the coupling element (11) such that it illuminates the interface between the first face and the ambient medium or the interface between a substrate (77) in optical contact with said first face and the ambient medium at an angle greater than the critical angle;
- means (82) for directing the object light beam (75) at the first face of the coupling element (11) such that it is aligned with the reference beam (74) in the plane of the holographic recording medium (79) on a substrate (79) in contact with the first face;
- means (29) for scanning and stepping the incident light beam (51) in a raster scan across the beam splitting means in a first and in a second direction, respectively, such that the reference and object beams (74,75) travel simultaneously across the first face or the substrate (79) in optical contact with the first face;
- second compression and/or expansion means (83) for compressing the reference beam (74) and/or expanding the object beam (75) in one direction in order to correct for their different incident angles at the first face so that the areas of intersection of the object and reference beams (74,75) with the first face or holographic recording medium (79) have the same shape and size;
  **characterized in that**
- the beam expansion optics includes first one-dimensional compression and/or one-dimensional expansion means (45,47) which are arranged in the light path (51) such that the output of the beam expansion optics (27) is compressed in the first direction relative to the second direction, where the first direction corresponds to the direction of the scan passes in the raster scan pattern of the beam across the first face or substrate (79) and where the second direction corresponds essentially to the stepping direction in the raster scan pattern, to produce a beam whose dimension in the first direction is less than 0.7 times its dimension in the second direction.

7. Apparatus according to claim 6 characterized in that the one-dimensional compression and/or one-dimensional expansion means (45,47) are designed such that a beam (49) of an essentially elliptical or almost rectangular cross-section (43) is produced and that the first compression and/or first expansion means (45,47) are positioned in the light path between the light source (25) and the beam splitting means (81) and in that the second compression means (83) and/or second expansion means are positioned in the object and/or reference beam light path (75,74) between the beam splitting means (81) and the coupling element (11).

8. Method of reconstructing an image from a hologram (19) in a total internal reflection holographic imaging apparatus, comprising the following steps:

- arranging a hologram (19) on a coupling element (11) and in optical contact therewith;
- arranging a wafer (37) being coated with a recording medium (39) in a spaced relationship and parallel to the hologram (19);
- directing an illumination beam (23) to the hologram (19) in a way that the condition for total internal reflection at the interface between the hologram (19) and the ambient medium is fulfilled and in a reverse direction to the hologram formation process;
- scanning the illumination beam (23) in a first direction across the recording medium, stepping the illumination beam in a second direction perpendicular to the first direction, and then scanning the beam again in the first direction and so on,
  **further including the step of**
- compressing the illumination beam initially in the first direction relative to the second direction, where the first direction corresponds to the direction of the scan passes in a raster scan pattern of the beam across the hologram and where the second direction corresponds to the stepping direction in the raster scan pattern, to produce a beam such that its dimension in the first direction (a) is less than 0.7 times its dimension in the second direction (b), and so that in the hologram plane the light beam is scanned in the direction of the smaller beam diameter and stepped in the direction of the larger beam diameter.

9. Method according to claim 8 characterized in that the illumination beam (23) is expanded and/or compressed such that a beam (49) of an essentially elliptical or almost rectangular cross-section is produced and that the dimension of the compressed beam in the first direction is about a half or less of its dimension in the second direction and preferably one third or less of its dimension in the second direction.

10. Method according to claim 8 or 9 characterized in that the light beam (23) is compressed in the first direction and/or expanded in the second direction so that in a raster scan the light bean is scanned in the direction of the smaller beam diameter and stepped in the direction of the larger beam diameter.

11. Method according to any of the preceding claims 8 to 10 characterized in that the light beam (23) is compressed or expanded by two prisms (45,47) such that the light beams (23) before and after the prisms (45,47) are parallel.

12. Method according to any of the preceding claims 8 to 11 characterized in that the gap between the hologram (19) and the wafer (37) is determined, e.g. interferometrically, and then the distance between the hologram (19) and the recording medium (39) adjusted to a predetermined value.

13. Method according to any of the preceding claims 8 to 12 characterized in that two or more parallel beams (61,63) are generated and simultaneously scanned and stepped.

14. Method of forming a hologram from a information containing mask (76) in a total internal reflection holographic recording apparatus (71), comprising the following steps:

    - arranging a substrate (77) bearing a recording medium (79) on a coupling element (11) and in optical contact therewith;
    - arranging a information containing mask (76) in a spaced relationship and parallel to the substrate (79);
    - generating an illumination light beam (51) and then splitting the light beam in an object beam and a reference beam (75,74) ;
    - directing the reference beam (74) to the first face of the coupling element (11) in a way that the condition for total internal reflection at the interface between the recording medium (79) and the ambient medium is fulfilled;
    - directing the object beam (75) through the mask (73) to the substrate (77) such that it coincides with the reference beam (74) in the holographic recording medium (79);
    - scanning the illumination beam (51) in a first direction across the holographic recording medium (79 ) and the mask (73), respectively , stepping the illumination (51) beam in a second direction perpendicular to the first direction, and then scanning the beam (51) again in the first direction and so on, such that the reference and object beams (75,74) travel simultaneously across the first face or the substrate (77) in optical contact with the first face;
**further including the step of**

    - compressing the light beam (51) initially in the first direction relative to the second direction, where the first direction corresponds to the direction of the scan passes in a raster scan pattern of the beam across the holographic recording medium (79) and where the second direction corresponds essentially to the stepping direction in the raster scan pattern, to produce a beam such that its dimension in the first direction (a) is less than 0.7 times its dimension in the second direction (b), and so that in the plane of the holographic recording medium (79) the light beams are scanned in the direction of the smaller beam diameter and stepped in the direction of the larger beam diameter.

15. Method according to claim 14, characterized in that a beam (49) of an essentially elliptical or almost rectangular cross-section is produced and that the dimension of the compressed beam in the first direction is about a half or less of its dimension in the second direction and preferably one third or less of its dimension in the second direction.

16. Method according to claim 14 or 15 further comprising the step of compressing additionally the reference beam (74) and/or expanding the object beam (75) in one dimension in order to correct for their different shape and size due to their different incident angles at the first face so that the areas of intersection of the object and reference beams (75,74) with the holographic recording medium (79) have the same shape and size.

Fig. 1

EP 0 964 317 A1

Fig. 2

Fig. 3

Fig. 5

Fig. 4

Fig. 6

Fig. 7

Fig. 8

Fig. 9

Fig. 10

## EUROPEAN SEARCH REPORT

**European Patent Office**

**Application Number**

EP 98 30 3677

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| D,A | US 5 640 257 A (CLUBE FRANCIS S M) 17 June 1997 * column 5, line 5 - column 6, line 39 * * figure 2 * | 1,6,8, 14,16 | G03H1/00 H01L21/027 G03F7/20 |
| D,A | EP 0 421 645 A (HOLTRONIC TECHNOLOGIES LTD) 10 April 1991 * page 4, line 36 - page 5, line 4 * * claims; figure 3 * | 1,5,6,8, 12,14 | |
| A | US 4 623 791 A (KANEKO YUTAKA ET AL) 18 November 1986 * column 4, line 6 - line 28 * * column 5, line 23 - line 54 * * claim 5; figures 3,5,9,10 * | 1,2,6-9, 14,15 | |
| A | US 5 373 395 A (ADACHI YOSHI) 13 December 1994 * column 2, line 12 - line 35 * * claim 1; figures 1,3 * | 1-3,6-9, 11,14,15 | |
| | | | **TECHNICAL FIELDS SEARCHED (Int.Cl.6)** G03H H01L G03F |

The present search report has been drawn up for all claims

| Place of search | Date of completion of the search | Examiner |
|---|---|---|
| THE HAGUE | 7 October 1998 | Krametz, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

**ANNEX TO THE EUROPEAN SEARCH REPORT
ON EUROPEAN PATENT APPLICATION NO.**   EP 98 30 3677

This annex lists the patent family members relating to the patent documents cited in the above-mentioned European search report.
The members are as contained in the European Patent Office EDP file on
The European Patent Office is in no way liable for these particulars which are merely given for the purpose of information.

07-10-1998

| Patent document cited in search report | Publication date | Patent family member(s) | | Publication date |
|---|---|---|---|---|
| US 5640257 A | 17-06-1997 | GB | 2271648 A | 20-04-1994 |
| | | EP | 0593124 A | 20-04-1994 |
| | | JP | 6308872 A | 04-11-1994 |
| EP 0421645 A | 10-04-1991 | DE | 69029777 D | 06-03-1997 |
| | | DE | 69029777 T | 31-07-1997 |
| | | JP | 3139651 A | 13-06-1991 |
| US 4623791 A | 18-11-1986 | JP | 60172020 A | 05-09-1985 |
| US 5373395 A | 13-12-1994 | NONE | | |